# EUROPEAN PATENT APPLICATION

(11) **EP 4 668 058 A1**
(43) Date of publication of application: **24.12.2025**
(21) Application number: 25183342.2
(22) Date of filing: 17.06.2025
(51) Int. Cl.: G06F 1/20, H01L 23/367, H01L 23/473, H05K 7/20

(54) **LIQUID COOLING PLATE FOR COMPUTING SERVER, COMPUTING LIQUID COOLING UNIT, COMPUTING SERVER, AND DATA CENTER**

(30) Priority: 18.06.2024 CN 202421394897 U
(71) Applicant: Bitdeer Semiconductor Technology PTE. LTD., 049514 Singapore (SG)
(72) Inventor: YANG, Senfeng, 049514 Singapore (SG); LI, Weiguo, 049514 Singapore (SG); DAI, Qiang, 049514 Singapore (SG)
(74) Representative: Metida

(57) **Abstract**

Disclosed is a liquid cooling plate for a computing server, a computing liquid cooling unit, a computing server, and a data center. The liquid cooling plate comprises a medium flow channel, heat dissipation fins, and a flow guide structure. The medium flow channel has channel end walls, wherein medium ports are arranged in the channel end walls. The heat dissipation fins are arranged within the medium flow channel and are disposed between the channel end walls, dividing the medium flow channel into a plurality of sub-flow channels. The flow guide structure is arranged at least between one of the channel end walls and the heat dissipation fins, and the flow guide structure is evenly spaced apart from the channel end wall on a side where the flow guide structure is disposed and from the heat dissipation fins.

## Description

### TECHNICAL FIELD

The present disclosure relates to the technical field of liquid cooling, and in particular, relates to a liquid cooling plate for a computing server, a computing liquid cooling unit, a computing server, and a data center.

### BACKGROUND

With advancements in technologies, an increasing number of electronic devices employ liquid cooling solutions to address heat dissipation issues. For instance, servers used for highperformance computing, which contain numerous hash chips, exhibit substantial heat generation during operation of the hash chips. If this heat is not efficiently dissipated in a timely manner, the cumulated heat can adversely affect the performance and operational lifespan of the individual chips, and may even lead to device malfunctions or system crashes. In related arts, although liquid cooling plates have been employed to dissipate heat from the hash chips, and even heat dissipation fins are incorporated within flow channels of the liquid cooling plates, the high requirements of large-scale computing servers for temperature uniformity among the various computing chips still fail to be satisfied.

### SUMMARY

In view of the above situation, the present disclosure is mainly intended to provide a liquid cooling plate for a computing server, a computing liquid cooling unit, a computing server, and a data center that may enhance the uniformity of a medium in the liquid cooling plate across a width direction of a flow channel and improve capabilities of hash chips.

To achieve the above objective, the present disclosure employs the following technical solutions:
In a first aspect, embodiments of the present disclosure provide a liquid cooling plate for a computing server, the computing server including a hash board and the liquid cooling plate, the hash board being mounted on an outer surface of the liquid cooling plate, the hash board including a substrate and a plurality of hash chips, the plurality of hash chips forming a plurality of rows of chipsets on a same side of the substrate; wherein the liquid cooling plate includes a medium flow channel, heat dissipation fins, and a flow guide structure; wherein the medium flow channel is arranged corresponding to the chipsets; the medium flow channel has a channel end wall at each of both ends of the medium flow channel in an extension direction of the medium flow channel, medium ports being arranged in the channel end walls; and the heat dissipation fins are arranged within the medium flow channel and are disposed between the two channel end walls, dividing the medium flow channel into a plurality of sub-flow channels; and the flow guide structure is arranged at least between one of the channel end walls and the heat dissipation fins, and the flow guide structure is evenly spaced apart from the channel end wall on a side where the flow guide structure is disposed and from the heat dissipation fins; wherein the flow guide structure includes a first flow guide plate and a second flow guide plate that are arranged opposite to each other; wherein the first flow guide plate and the second flow guide plate protrude in directions facing away from each other; and a gap is defined between the first flow guide plate and the second flow guide plate in a width direction of the medium flow channel, a dimension of the gap at an end closer to the channel end wall is less than a dimension of the gap at an end closer to the heat dissipation fins.

In some embodiments, each of the first flow guide plate and the second flow guide plate includes a first straight plate segment and a second straight plate segment that are connected by a bend; wherein the first straight plate segment is closer to the medium port, and for each of two said first straight plate segments, one end thereof closer to the channel end wall is further away from the channel side wall than the other end thereof; and two said second straight plate segments are arranged in parallel.

In some embodiments, in the extension direction, a dimension of the first straight plate segment is greater than a dimension of the second straight plate segment.

In some embodiments, an included angle between the two first straight plate segments is from 45° to 75°.

In some embodiments, at an end of the flow guide structure closer to the medium port, a distance between the first flow guide plate and the second flow guide plate is 1/3 to 1/2 of a maximum width of the medium port, wherein the width of the medium port is a dimension in the width direction of the medium flow channel.

In some embodiments, the first flow guide plate and the second flow guide plate are both curved plates.

In some embodiments, for each of the first flow guide plate and the second flow guide plate, an end face thereof closer to the channel end wall and two opposite side surfaces thereof are smoothly transitioned.

In some embodiments, the flow guide structure further includes a third flow guide plate, wherein the third flow guide plate is disposed between the first flow guide plate and the second flow guide plate.

In some embodiments, one of the medium ports is a liquid inlet, and the flow guide structure is arranged at the liquid inlet; and a plurality of the heat dissipation fins are juxtaposed in the width direction of the medium flow channel, and ends of the plurality of the heat dissipation fins closer to the liquid inlet are flush.

In some embodiments, the plurality of the heat dissipation fins are spaced apart along the extension direction to form a plurality of heat dissipation groups, each of the heat dissipation groups including a plurality of the heat dissipation fins; and the medium flow channel includes a plurality of sub-segments sequentially communicated; wherein in a sub-segment where the liquid inlet is disposed, both a distance between the heat dissipation group closest to the flow guide structure and the flow guide structure and a distance between two heat dissipation groups closest to the flow guide structure are greater than a distance between any adjacent heat dissipation groups of the plurality of heat dissipation groups.

In a second aspect, embodiments of the present disclosure provide a computing liquid cooling unit. The computing liquid cooling unit includes the liquid cooling plate as described above.

In some embodiments, the computing liquid cooling unit further includes a hash board, the hash board being mounted on an outer side surface of the liquid cooling plate; wherein an enclosure of the liquid cooling plate includes a bottom shell and a cover plate that are fitted to each other, the bottom shell comprising a bottom plate, a shell wall protruding from the bottom plate, and a partition strip, the partition strip being disposed within the shell wall; wherein the partition strip, the shell wall, the bottom plate, and the cover plate form a medium flow channel; a plurality of positioning pillars are arranged on at least a partial segment of each of the partition strip and the shell wall, first mounting holes being arranged in the positioning pillars; positioning holes corresponding to the positioning pillars are arranged in the cover plate; and the heat dissipation fins and the flow guide structure are both disposed on the bottom plate; second mounting holes corresponding to the first mounting holes are arranged in the hash board; and the cover plate is fitted onto the bottom plate, the positioning pillars and positioning holes that are in correspondence are in a positioning fit configuration, and the hash board is locked onto the bottom shell by spring screws engaging with the corresponding first mounting holes, wherein two ends of a spring of the spring screw are disposed between the screw head and the hash board.

In some embodiments, the positioning pillars are arranged on two opposite first segments of the shell wall in the width direction, and a positioning boss is further arranged on a second segment connecting two said first segments; and a positioning notch is arranged in a corresponding edge of the cover plate, and the positioning boss is in positioning engagement with the positioning notch.

In some embodiments, the hash board includes a substrate, a plurality of hash chips, a power supply interface, and a signal interface; wherein the plurality of hash chips are arranged on a same surface of the substrate and are in contact with the liquid cooling plate; and the power supply interface and the signal interface are arranged at a same edge of the substrate and are both electrically connected to the hash chips.

In a third aspect, embodiments of the present disclosure provide a computing server. The computing server includes the computing liquid cooling plate as described above.

In a fourth aspect, embodiments of the present disclosure provide a data center. The data center includes the computing server as described above.

In the liquid cooling plate according to the present disclosure, by arranging the flow guide structure between the medium port and the heat dissipation fins, and causing the two flow guide plates of the flow guide structure to protrude in the directions facing away from each other, and configuring a distance between the two flow guide plates at one end closer to the medium port to be less than that at the other end, a medium flow at the medium port and between the medium port and the heat dissipation fins is better distributed into sub-flow channels formed by the heat dissipation fins, or is better converged from the sub-flow channels to the medium port. This ensures consistency of flow velocity and temperature of the medium flow across the width direction of the medium flow channel , thereby improving the overall heat dissipation performance of the liquid cooling plate. When the liquid cooling plate is assembled with the hash board, it is ensured that temperatures of the hash chips at a same location across the width direction on the medium flow channel are kept as consistent as possible, thereby improving the performance of the hash board and extending the service life of the hash board. Meanwhile, according to the present disclosure, a space between the flow guide structure and the medium port and the heat dissipation fins forms a buffer zone, thereby avoiding turbulence caused by abrupt changes in the flow channel, reducing air in the medium flow, and further improving the heat dissipation performance of the liquid cooling plate.

Other beneficial effects of the present disclosure are described in retail with reference to specific technical features and technical solutions in the specific embodiments. A person skilled in the art may understand the beneficial effects achieved by these technical features and technical solutions through description of these technical features and technical solutions.

### BRIEF DESCRIPTION OF THE DRAWINGS

Some embodiments of the present disclosure are described with reference to accompanying drawings hereinafter.
FIG. 1 is a schematic structural view of a liquid cooling plate according to some embodiments of the present disclosure;
FIG. 2 is a schematic partial structural view of a bottom shell in a liquid cooling plate according to some embodiments of the present disclosure;
FIG. 3 is a schematic structural view of a flow guide structure in a liquid cooling plate according to some embodiments of the present disclosure;
FIG. 4 is a schematic structural view of a flow guide structure in a liquid cooling plate according to some embodiments of the present disclosure;
FIG. 5 is a schematic structural view of a flow guide structure in a liquid cooling plate according to some embodiments of the present disclosure;
FIG. 6 is a schematic structural view of a computing liquid cooling unit according to some embodiments of the present disclosure;
FIG. 7 is a schematic exploded view of a computing liquid cooling unit according to some embodiments of the present disclosure; and
FIG. 8 is a cross-sectional view of a computing liquid cooling unit in FIG. 6 according to some embodiments of the present disclosure.

Reference numerals and denotations thereof: 10-liquid cooling plate; 11-medium flow channel; 111-flow channel end wall; 1111-medium ports; 112-flow channel side wall; 113-bottom wall; 114-sub-segment; 12-heat dissipation fin; 121-first heat dissipation group; 122-second heat dissipation group; 123-third heat dissipation group; 13-flow guide structure; 131-first flow guide plate; 1311-first straight plate segment; 1312-second straight plate segment; 132-second flow guide plate; 133-third flow guide plate; 14-enclosure; 141-base shell; 1411-base plate; 1412-shell wall; 1413-partition strip; 1414-positioning pillar; 1415-positioning boss; 142-cover plate; 20-hash board; 21-substrate; 22-hash chip; 23-power supply interface; 24-signal interface; and 30-spring screw.

### DETAILED DESCRIPTION

The present disclosure is described with reference to some exemplary embodiments. However, the present disclosure is not limited to these exemplary embodiments. In the detailed description of the present disclosure, specific details are set forth. To avoid unnecessarily obscuring the substance of the present disclosure, well-known methods, procedures, processes, and components have not been described in detail.

Furthermore, it should be understood by persons of ordinary skill in the art that the drawings provided herein are for illustrative purposes only and are not necessarily drawn to scale.

Unless the context clearly requires otherwise, throughout this specification and the claims, the words "comprise," "contain," and the like are to be construed in an inclusive sense, as opposed to an exclusive or exhaustive sense, that is, in the sense of "including, but not limited to."

It should be noted that terms such as "first," "second," and the like are merely used for illustration purpose during the description of the present disclosure, and shall not be understood as indicating or implying relative importance. In addition, in the description of the present disclosure, the term "multiple," "more," or "a plurality of" refers to at least two unless otherwise specified.

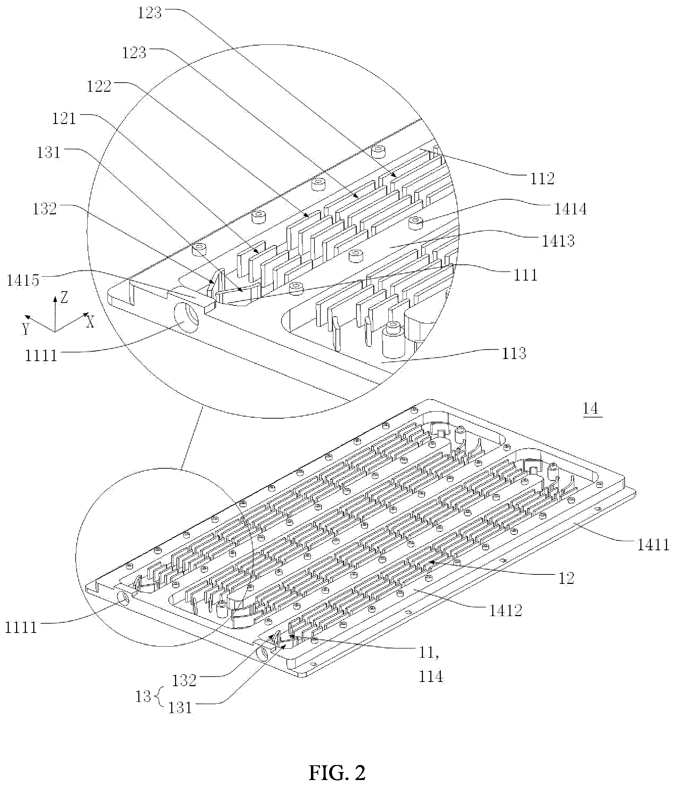

For convenience of description, a Cartesian coordinate system is established with an extension direction X, a width direction Y, and a depth direction Z of a medium flow channel in a liquid cooling plate. It should be noted that the extension direction X and the width direction Y of the medium flow channel described herein both refer to an extension direction of the medium flow channel at a described location. FIG. 2 merely shows an extension direction X and a width direction Y at a sub-segment 114. An extension direction at a connecting segment that connects sub-segments is a curved direction, and the width direction Y is a radial direction of the connecting segment. It should be noted that the establishment of this coordinate system is solely for convenience of description and does not impose specific limitations on the state of use of the liquid cooling plate. During use or placement, the respective directions may be defined according to the actual orientation or operating state of the liquid cooling plate.

Some embodiments of the present disclosure provide a liquid cooling plate 10, which can be used to dissipate heat for components of an electronic device, such as hash chips (computing chips). Specifically, when used for a computing server, the liquid cooling plate 10 is configured to dissipate heat for hash chips, which are components that generate heat during running on a hash board (computing board) of the server. The computing server includes a hash board 20 and the liquid cooling plate. The hash board 20 is mounted on an outer surface of the liquid cooling plate. The hash board 20 includes a substrate 21 and a plurality of hash chips 22. The plurality of hash chips 22 form a plurality of rows of chipsets on a same surface of the substrate 21. The specific structure of the hash board 20 is described in detail hereinafter.

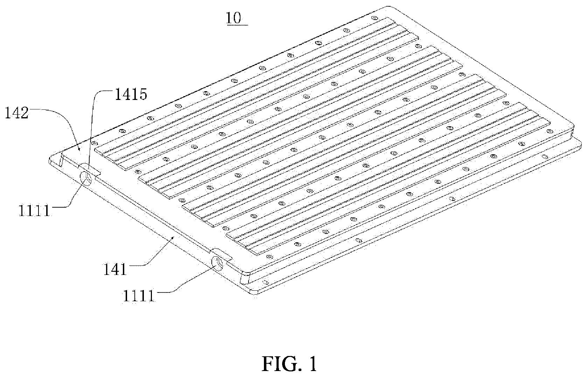

Referring to FIG. 1 to FIG. 5, the liquid cooling plate 10 includes a medium flow channel 11, heat dissipation fins 12, and a flow guide structure 13. The medium flow channel 11 is arranged corresponding to the chipsets. The medium flow channel 11 has channel end walls 111 at two ends thereof in an extension direction X of the medium flow channel 11, and a medium port 1111 is arranged in each of the channel end walls 111. The heat dissipation fins 12 are arranged within the medium flow channel 11 and are disposed between the two channel end walls 111. The heat dissipation fins 12 extend along the extension direction X of the medium flow channel 11, dividing the medium flow channel 11 at a location thereof into a plurality of sub-flow channels. The plurality of sub-flow channels are juxtaposed in a width direction Y of the medium flow channel 11. The flow guide structure 13 is arranged at least between one of the channel end walls 111 and the heat dissipation fins 12, and the flow guide structure 13 is evenly spaced apart from the channel end wall 111 on a side where the flow guide structure 13 is disposed and from the heat dissipation fins 12. As illustrated in FIG. 2, one channel end wall 111 of the medium flow channel 11 is denoted as a first channel end wall, and the other channel end wall 111 is denoted as a second channel end wall; and an end of the heat dissipation fin 12 close to the first channel end wall is denoted as a first heat dissipation end, and an end thereof close to the second channel end wall is denoted as a second heat dissipation end. The flow guide structure 13 may be arranged only between the first channel end wall and the first heat dissipation end, wherein the flow guide structure 13 is spaced apart from both the first channel end wall and the first heat dissipation end, that is, the flow guide structure 13 is not in contact with either the first channel end wall or the first heat dissipation end. Alternatively, the flow guide structure 13 may be arranged only between the second channel end wall and the second heat dissipation end, wherein the flow guide structure 13 is spaced apart from both the second channel end wall and the second heat dissipation end, that is, the flow guide structure 13 is not in contact with either the second channel end wall or the second heat dissipation end. Alternatively, flow guide structures 13 may be simultaneously arranged between the first channel end wall and the first heat dissipation end, and between the second channel end wall and the second heat dissipation end; and nevertheless, the flow guide structure 13 is not in contact with any channel end wall 111 or the heat dissipation fin 12.

Still referring to FIG. 2 to FIG. 5, the flow guide structure 13 includes a first flow guide plate 131 and a second flow guide plate 132 which are oppositely arranged. The first flow guide plate 131 and the second flow guide plate 132 protrude in directions facing away from each other, and a gap is defined therebetween in the width direction Y of the medium flow channel 11. A dimension of the gap closer to the channel end wall 111 is less than a dimension thereof closer to the heat dissipation fins 12. That is, a distance between the first flow guide plate 131 and the second flow guide plate 132 in the width direction Y varies, and the distance increases in a direction from the channel end wall 111 towards the heat dissipation fins 12. In other words, the first flow guide plate 131 and the second flow guide plate 132 form a funnel-like structure, wherein an opening of the funnel-like structure at a first end of the flow guide structure 13 closer to the medium port 1111 is less than that at a second end thereof closer to the heat dissipation fins 12. That is, at the first end, a distance between the first flow guide plate 131 and the second flow guide plate 132 is relatively small, and the first flow guide plate 131 and the second flow guide plate 132 do not intersect on a side closer to the medium port 1111, but rather this relatively small distance is maintained; and at the second end, a distance between the first flow guide plate 131 and the second flow guide plate 132 is relatively large.

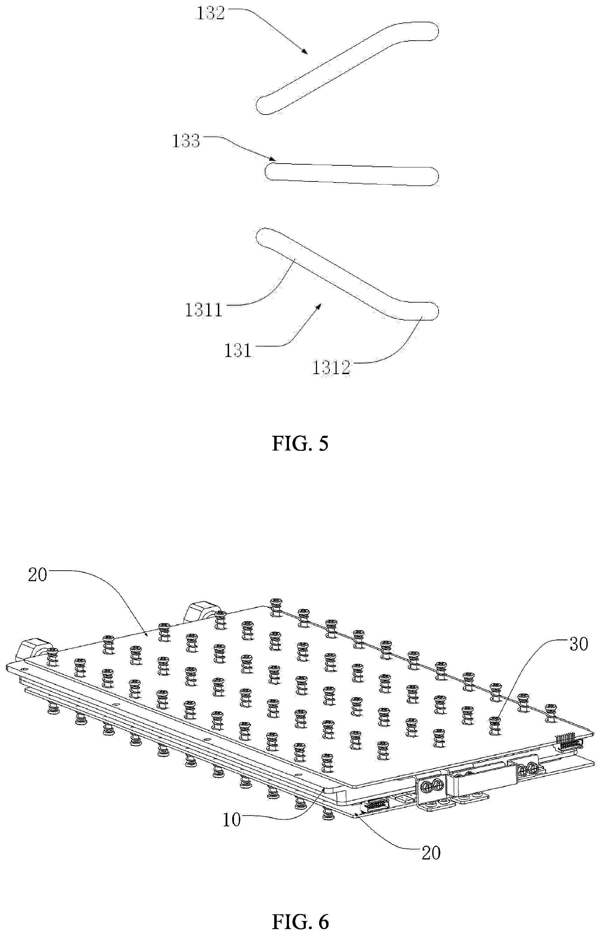

In the liquid cooling plate 10 according to the present disclosure, by arranging the flow guide structure 13 between the medium port 1111 and the heat dissipation fins 12, and causing the two flow guide plates (i.e., the first flow guide plate 131 and the second flow guide plate 132) of the flow guide structure 13 to protrude in the directions facing away from each other, and configuring a distance between the two flow guide plates at one end closer to the medium port 1111 to be less than that at the other end, a medium flow at the medium port 1111 and between the medium port 1111 and the heat dissipation fins 12 is better distributed into sub-flow channels formed by the heat dissipation fins 12, or is better converged from the sub-flow channels to the medium port 1111. This ensures consistency of flow velocity and temperature of the medium flow across the width direction Y of the medium flow channel 11, thereby improving the overall heat dissipation performance of the liquid cooling plate 10. When the liquid cooling plate 10 is assembled with the hash board 20 (referring to FIG. 6), it is ensured that temperatures of the hash chips 22 at a same location across the width direction Y on the medium flow channel 11 are kept as consistent as possible, thereby improving the performance of the hash board 20 and extending the service life of the hash board 20. Meanwhile, according to the present disclosure, a space between the flow guide structure 13 and the medium port 1111 and the heat dissipation fins 12 forms a buffer zone, thereby avoiding turbulence caused by abrupt changes in the flow channel, reducing air in the medium flow, and further improving the heat dissipation performance of the liquid cooling plate 10.

The medium flow channel 11 further has two channel side walls 112, a bottom wall 113, and a top wall (not illustrated in the drawings), which extend along the medium flow channel 11. The two channel end walls 111 are perpendicular to the extension direction X, and the two channel side walls 112 are parallel to the extension direction X. Each of the channel side walls 112 is connected to the two channel end walls 111. The top wall and the bottom wall 113 are oppositely arranged in a height direction. The channel end walls 111 and the channel side walls 112 are connected to the bottom wall 113 along an edge of the bottom wall 113, and are also connected to the top wall along an edge of the top wall, thereby enclosing the medium flow channel 11 by the two channel end walls 111, the two channel side walls 112, the bottom wall 113, and the top wall. The flow guide structure 13 (including the first flow guide plate 131 and the second flow guide plate 132) and the heat dissipation fins 12 may be connected to the bottom wall 113 and may be in contact with the top wall at the same time, or a gap may be defined between flow guide structure 13 and the heat dissipation fins 12 and the top wall of the flow channel. The heat dissipation fins 12 may also be directly arranged on the bottom wall 143 of the flow channel, and may be in contact with the top wall of the flow channel, or a gap may be defined between the heat dissipation fins 12 and the top wall of the flow channel. Of the two channel end walls 111, the medium port 1111 on one channel end wall 111 serves as a liquid inlet, and the medium port 1111 on the other channel end wall 111 serves as a liquid outlet, such that the medium enters the medium flow channel 11 through the liquid inlet, and flows out from the liquid outlet.

The medium flow channel 11 may include a plurality of sub-segments 114, and the sub-segments may be juxtaposed in the width direction Y and sequentially communicated. That is, these sub-segments 114 are connected in series, and an outlet end of one sub-segment serves as an inlet end of an adjacent other sub-segment. End portions of the first and last sub-segments 114 form the channel end walls 111. Each of the sub-segments 114 corresponds to at least one row of chipsets. That is, each of the sub-segments 114 may dissipate heat for a corresponding one row or plurality of rows of chipsets.

A distance is defined between the flow guide structure 13 and each of the two channel side walls 112. Thus, at the flow guide structure 13, the medium flow is divided into a portion between the first flow guide plate 131 and the second flow guide plate 132, a portion between the first flow guide plate 131 and the channel side wall 112 on a same side thereof, and a portion between the second flow guide plate 132 and the channel side wall 112 on a same side thereof.

Specifically, the first flow guide plate 131 and the second flow guide plate 132 are respectively disposed on two sides of a center plane of the medium flow channel 11. That is, the first flow guide plate 131 and the second flow guide plate 132 are symmetrically distributed with respect to the center plane, forming a funnel-like structure. The center plane of the medium flow channel 11 refers to a plane parallel to the extension direction X at a location thereof and passing through a centerline of the width direction Y of the medium flow channel 11. Each of the first flow guide plate 131 and the second flow guide plate 132 may be a curved plate, or may be a bent plate formed by bending a flat plate. Regardless of which structure the first flow guide plate 131 and the second flow guide plate 132 adopt, each of the first flow guide plate 131 and the second flow guide plate 132 protrudes towards a side away from the center plane.

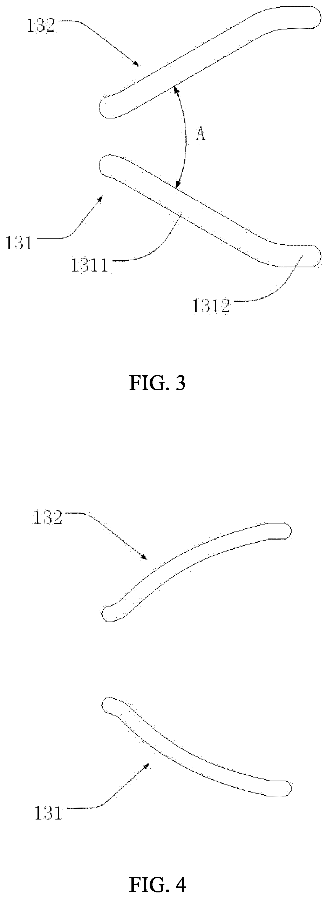

In some embodiments, as illustrated in FIG. 3, each of the first flow guide plate 131 and the second flow guide plate 132 includes a first straight plate segment 1311 and a second straight plate segment 1312 that are connected by bending. The first straight plate segment 1311 is closer to the medium port 1111, and for the two first straight plate segments 1311, one end thereof closer to the channel end wall 111 is further from a channel side wall 112 than the other end thereof. The two second straight plate segments 1312 are arranged parallel to each other. As illustrated in FIG. 2, the first straight plate segment 1311 and the second straight plate segment 1312 are both flat plates, and the first straight plate segment 1311 is arranged inclinedly relative to the extension direction X. That is, one end of the first straight plate segment 1311 closer to the medium port 1111 is closer to the center plane of the medium flow channel 11 than the other end thereof. A distance between the two first straight plate segments 1311 progressively increases in a direction from the channel end wall 111 on a side thereof towards the heat dissipation fin 12, such that the two first straight plate segments 1311 form a structure with a smaller opening at an end closer to the medium port 1111 and a larger opening at an end further from the medium port 1111. The two second straight plate segments 1312 are disposed at the position of the larger opening. A distance between the two second straight plate segments 1312 remains unchanged in the extension direction X, that is, the two second straight plate segments 1312 are arranged parallel to each other. Further, the two second straight plate segments 1312 are parallel to the extension direction X. Thus, after being distributed by the first straight plate segments 1311, the medium flow may be further guided by the second straight plate segments 1312 to continue flowing in a direction parallel to the extension direction X, thereby reducing resistance to the medium flow, avoiding turbulence as much as possible, and thus further improving temperature consistency of hash chips at a same location in the width direction Y of the medium flow channel 11.

In some embodiments, the first straight plate segment 1311 and the second straight plate segment 1312 have a smooth transition therebetween. In some embodiments, a dimension of the first straight plate segment 1311 is greater than a dimension of the second straight plate segment 1312, such that the medium flow has a sufficient distribution distance to achieve a better flow equalization effect. Further, an included angle A between the first straight plate segment 1311 and the second straight plate segment 1312 is from 45° to 75°. Referring to FIG. 3, for example, the included angle A may be 45°, 50°, 55°, 60°, 65°, 70°, 75°, or the like. Preferably, the included angle A is 60°. Thus, in a case where the flow guide structure 13 is disposed on a liquid inlet side, the flow guide structure 13 neither causes the medium flow to be too dispersed when being guided to avoid excessive impact of a portion of the medium flow against the channel side walls 112 from generating bubbles, nor does it prevent the medium flow from better entering respective sub-flow channels formed by the heat dissipation fins 12 after being distributed. In a case where the flow guide structure 13 is disposed on a liquid outlet side, the flow guide structure 13 allows the medium flow emerging from the respective sub-flow channels to enter the outlet through an internal space of the flow guide structure 13 as much as possible, while also avoiding turbulence due to flow channel changes at the flow guide structure 13, and allows a portion of the medium flow between the flow guide structure 13 and the channel side walls 112 to smoothly enter the outlet under guidance of outer walls of the flow guide structure 13, thereby minimizing collision with the channel end walls 111.

Furthermore, on a side of the flow guide structure 13 closer to the medium port 1111, a distance between the first flow guide plate 131 and the second flow guide plate 132 is 1/3 to 1/2 of a maximum width of the medium port 1111. That is, a minimum distance between the first flow guide plate 131 and the second flow guide plate 132 is 1/3 to 1/2 of the maximum width of the medium port 1111, for example, 0.33 times, 0.34 times, 0.36 times, 0.38 times, 0.4 times, 0.43 times, 0.45 times, 0.48 times, or 0.5 times the maximum width of the medium port 1111, so as to further improve the flow equalization effect of the flow guide structure 13. The width of the medium port 1111 refers to a dimension thereof in the width direction of the medium flow channel. For example, in a case where the medium port 1111 is a circular hole, the maximum width thereof is a diameter of the circular hole.

In some other embodiments, each of the first flow guide plate 131 and the second flow guide plate 132 is a curved plate. As illustrated in FIG. 4, two opposite and relatively large surfaces of the curved plate (i.e., surfaces that achieve a flow guide effect) are curved surfaces, such as a circular arc-shaped plate, an elliptical arc-shaped plate, a parabolic plate, a hyperbolic plate, a free-form curved plate, or the like. Nevertheless, the first flow guide plate 131 and the second flow guide plate 132 may also be other curved plates. A circular arc-shaped plate means that the curved surface of the curved plate is a circular arc surface; an elliptical arc-shaped plate means that the curved surface of the curved plate is a portion of an elliptical surface; a parabolic plate means that the curved surface of the curved plate is a portion of a parabolic surface; a hyperbolic plate means that the curved surface of the curved plate is a portion of a hyperbolic surface; and a free-form curved plate means that the curved surface of the curved plate is a portion of a free-form surface.

For each of the first flow guide plate 131 and the second flow guide plate 132, an end face thereof closer to the medium port 1111 is provided with rounded corners. For each of the first flow guide plate 131 and the second flow guide plate 132, the end face thereof has a smooth transition with two opposite side surfaces thereof. That is, the end face of the first flow guide plate 131 and the two flow guide surfaces thereof all have smooth transitions, and the end face of the second flow guide plate 132 and the two flow guide surfaces thereof all have smooth transitions, as illustrated in FIG. 3 to FIG. 5. In this way, resistance against the medium flow is further reduced.

In some other embodiments, the flow guide structure 13 further includes a third flow guide plate 133. The third flow guide plate 133 is disposed between the first flow guide plate 131 and the second flow guide plate 132. By adding the third flow guide plate 133, the medium flow may be better dispersed at the flow guide structure 13 (when disposed on the liquid inlet side) or gradually converged (when disposed on the liquid outlet side). Further, only one third flow guide plate 133 may be provided, or a plurality of third flow guide plates 133 may be provided. In a case where a plurality of third flow guide plates 133 are provided, a quantity of the third flow guide plates 133 is less than a quantity of the heat dissipation fins 12 in the width direction within the medium flow channel 11 minus 2, such that a quantity of sub-flow channels formed at the flow guide structure 13 is less than a quantity of sub-flow channels formed at the heat dissipation fins 12.

Specifically, the quantity of sub-flow channels into which the flow guide structure 13 divides the flow may be selected according to arrangement of components to be cooled. For example, in a case where the components to be cooled (specifically, hash chips as described hereinafter) are arranged in a plurality of columns, and one sub-segment corresponds to three columns of components to be cooled, only the first flow guide plate 131 and the second flow guide plate 132 may be provided. In a case where one sub-segment corresponds to even more columns of components to be cooled, one or two third flow guide plates 133 may be further provided.

In the width direction of the medium flow channel 11, only one heat dissipation fin 12 may be provided, or a plurality of heat dissipation fins 12 may be provided. In a case where a plurality of heat dissipation fins 12 are provided, the plurality of heat dissipation fins 12 are spaced apart in the width direction Y of the medium flow channel 11, and a gap is also defined between the two outermost heat dissipation fins 12 and the channel side walls 112. The medium flow channel 11 is divided into a plurality of sub-flow channels by the heat dissipation fins 12.

In the extension direction X, the plurality of heat dissipation fins 12 may form one heat dissipation group, or may be spaced apart form a plurality of heat dissipation groups. Each of the heat dissipation groups includes a plurality of heat dissipation fins 12 spaced apart along the width direction Y. In embodiments where only one heat dissipation group is formed, each of the heat dissipation fins 12 in the heat dissipation group extends from a position close to the liquid inlet to a position close to the liquid outlet, and is substantially arranged along the entire medium flow channel 11. In embodiments where a plurality of heat dissipation groups are formed, as illustrated in FIG. 2, a first heat dissipation group 121, a second heat dissipation group 122, and a third heat dissipation group 123 are provided. The plurality of heat dissipation groups are spaced apart along the extension direction X. Each of the heat dissipation groups includes a plurality of heat dissipation fins 12 spaced apart in the width direction Y. Each of the heat dissipation fins 12 in each of the heat dissipation groups is arranged only along a partial region of the medium flow channel 11. In a case where the medium flow channel 11 includes a plurality of sub-segments 114 communicated by bends, a plurality of heat dissipation groups may be arranged in each sub-segment 114. By means of the plurality of heat dissipation groups that are spaced apart, a possibility of turbulence occurring in the medium flow may be reduced, thereby preventing bubbles caused by turbulence from affecting heat transfer performance of the medium flow, and hence improving the overall heat dissipation performance of the liquid cooling plate 10.

In some embodiments, a flow guide structure 13 is arranged at the liquid inlet, and a plurality of heat dissipation fins 12 are juxtaposed in the width direction Y of the medium flow channel 11. Ends of the heat dissipation fins 12 closer to the liquid inlet are flush. As illustrated in FIG. 2, a medium port in an upper left portion in FIG. 2 is a medium inlet. In the vicinity of the medium inlet, end portions of the plurality of heat dissipation fins 12 closer to the flow guide structure 13 are flush, and distances between the ends of the heat dissipation fins 12 closer to the flow guide structure 13 and the flow guide structure 13 are equal. In a case where a plurality of heat dissipation groups are provided, end portions of the heat dissipation fins 12 in a heat dissipation group adjacent to the flow guide structure 13 are flush. This allows the medium flow from the medium inlet, after passing through the flow guide structure, to be substantially uniformly distributed into the sub-flow channels formed by the plurality of heat dissipation fins 12, thereby further improving the flow equalization effect.

Still referring to FIG. 2, in embodiments where a plurality of heat dissipation groups are provided and a flow guide structure 13 is arranged at the liquid inlet, in a sub-segment 114 of the medium flow channel 11 where the liquid inlet is disposed, a distance between the heat dissipation group closest to the flow guide structure 13 and the flow guide structure 13, and a distance between the two heat dissipation groups closest to the flow guide structure 13 are both greater than a distance between other adjacent two heat dissipation groups. As illustrated in FIG. 2, in the sub-segment 114 where the liquid inlet is located, the heat dissipation group closest to the flow guide structure 13 is denoted as a first heat dissipation group 121, the heat dissipation group next closest to the flow guide structure 13 is denoted as a second heat dissipation group 122, and other heat dissipation groups located in the sub-segment 114 where the flow guide structure 13 is located are denoted as third heat dissipation groups 123. A distance between the flow guide structure 13 and the first heat dissipation group 121 is a first distance (i.e., a distance between two ends thereof that are close to each other). A distance between the second heat dissipation group 122 and a third heat dissipation group 123 is a second distance (i.e., a distance between two ends thereof that are close to each other). A distance between two adjacent third heat dissipation groups 123 is a third distance (i.e., a distance between two ends thereof that are close to each other). Then, both the first distance and the second distance are greater than the third distance. Further, lengths of the two heat dissipation groups closest to the flow guide structure 13 are less than lengths of other heat dissipation groups, that is, lengths of the first heat dissipation group 121 and the second heat dissipation group 122 are both less than a length of a third heat dissipation group 123. Thus, turbulence caused by the medium flow near the liquid inlet of the heat dissipation fins 12 is further reduced, and a convergence effect of the flow guide structure 13 at that location is further enhanced, thereby increasing a flow velocity of the entire medium flow.

As illustrated in FIG. 1 and FIG. 2, the liquid cooling plate 10 includes an enclosure 14. The medium flow channel 11 is arranged inside the enclosure 14. That is, an inner cavity of the enclosure 14 forms a channel for medium circulation. The medium port 1111 passes through a shell wall and communicates the medium flow channel 11 with the exterior. Specifically, the enclosure 14 includes a bottom shell 141 and a cover plate 142 which are engaged with each other. The bottom shell 141 includes a bottom plate 1411, and a shell wall 1412 and a partition strip 1413 which protrude from the bottom plate 1411. The shell wall 1412 has an annular structure. The partition strip 1413 is located within the shell wall 1412. One end of the partition strip 1413 is connected to the shell wall 1412, and a gap is left between the other end thereof and the shell wall 1412. Thus, the partition strip 1413, the shell wall 1412, the bottom plate 1411, and the cover plate 142 enclose to form the medium flow channel 11. The channel end walls 111 are formed on an inner wall of the shell wall 1412, the channel side walls 112 are formed on the inner wall of the shell wall 1412 and on side walls of the partition strip 1413, the channel bottom wall 113 is formed on an inner surface of the bottom plate 1411, and a channel top wall is formed on an inner surface of the cover plate 142. The heat dissipation fins 12 and the flow guide structure 13 are both arranged on the bottom plate 1411. The heat dissipation fins 12, the flow guide structure 13, and the bottom shell 141 may be integrally formed.

Referring to FIG. 2, a plurality of positioning pillars 1414 are arranged on at least a partial segment of each of the partition strip 1413 and the shell wall 1412. First mounting holes are arranged in the positioning pillars 1414. Positioning holes corresponding to the positioning pillars 1414 are arranged in the cover plate 142. The cover plate 142 is engaged with the bottom shell 141, and each of the positioning pillars 1414 is in positioning engagement with a corresponding positioning hole. The cover plate 142 and the bottom shell 141 may also be connected by welding, specifically by brazing, such that the cover plate 142 and the bottom shell 141 form an integral structure, and at the same time, solder fills gaps between the cover plate and the bottom shell to ensure that the medium does not leak within the medium flow channel 11.

Furthermore, positioning pillars 1414 are arranged in two opposite first segments of the shell wall 1412 in the width direction Y, and positioning bosses 1415 are further arranged on a second segment connecting the two first segments. Positioning notches are arranged in edges of the cover plate 142 corresponding to the first segments. The positioning bosses 1415 are in positioning engagement with the positioning notches. That is, the shell wall 1412 includes first segments and a second segment; the first segments extend along the extension direction X, and the second segment extends in the width direction Y and connects two first segments.

By adding the positioning engagement of the positioning pillars 1414 with the positioning holes, and of the positioning bosses 1415 with the positioning notches, positional accuracy of the cover plate 142 relative to the medium flow channel 11 is further improved, thereby improving positional accuracy of the hash board 20 mounted on the cover plate 142 relative to the medium flow channel 11, and hence ensuring that all hash chips 22 on the hash board 20 are located on an outer surface of the enclosure 14 corresponding to the medium flow channel 11. In this way, the performance of the entire computing liquid cooling unit is enhanced.

Some embodiments of the present disclosure further provide a computing liquid cooling unit. As illustrated in FIG. 6 to FIG. 8, the computing liquid cooling unit includes the liquid cooling plate according to any one of the preceding embodiments.

The computing liquid cooling unit further includes a hash board 20. The hash board 20 includes a substrate 21 and a plurality of hash chips 22. The plurality of hash chips 22 are arranged on a same surface of the substrate 21. The hash board 20 is mounted on an outer side surface of the liquid cooling plate 10, i.e., an outer surface corresponding to the medium flow channel 11. Specifically, the hash board 20 is mounted on at least one outer surface of the enclosure 14 facing away from the medium flow channel 11. For example, the hash board 20 is mounted only on a surface of the cover plate 142 facing away from the bottom plate 1411, or is mounted only on a surface of the bottom plate 1411 facing away from the cover plate 142, or hash boards 20 may be simultaneously mounted on both of these surfaces, i.e., two hash boards 20 are mounted. As illustrated in FIG. 6, the two hash boards 20 and the liquid cooling plate 10 form a sandwich structure. Thus, the liquid cooling plate 10 is capable of dissipating heat for the hash board 20, such that temperatures of the hash chips 22 on the hash board 20 are kept as consistent as possible, and the performance of the entire hash board 20 is enhanced.

Further, each of the hash chips 22 is in contact with the enclosure 14 (including direct contact and indirect contact), and corresponds to a region on the enclosure 14 where the medium flow channel 11 is disposed. That is, the medium flow channel 11 and the hash chips 22 are respectively disposed on two sides of the enclosure 14 in a depth direction Z of the medium flow channel 11. In this way, the heat conduction performance of the medium flow to the hash chips 22 is further enhanced.

The plurality of hash chips 22 are arranged into a plurality of columns of chipsets arranged along the width direction Y. Each of the chipsets includes a plurality of hash chips 22 spaced apart along the extension direction X. Each column of chipsets is in contact with a region on the enclosure 14 where the medium flow channel 11 is arranged. In a case where the medium flow channel 11 is provided with a plurality of sub-segments 114, regions on the enclosure 14 where the sub-segments 114 are arranged respectively correspond to and are in contact with a plurality of columns of chipsets. In this case, each of the chipsets may be in contact with a region on the enclosure 14 where a sub-segment 114 is arranged, and one sub-segment 114 simultaneously corresponds to a plurality of columns of chipsets. Thus, each of the sub-segments 114 can simultaneously conduct heat for a plurality of columns of chipsets, thereby improving heat dissipation efficiency, and at the same time, ensuring that temperatures of these chipsets corresponding to the same sub-segment 114 in the width direction are kept as consistent as possible.

It is to be understood that the hash board 20 further includes a power supply interface 23 and a signal interface 24. The plurality of hash chips 22 are arranged on a same surface of the substrate 21 and are in contact with the liquid cooling plate 10. The power supply interface 23 and the signal interface 24 are arranged at a same edge of the substrate 21, and are both electrically connected to the hash chips 22, so as to supply power to and transmit signals for the hash chips 22.

The hash board 20 and the liquid cooling plate 10 may be locked by screws, and may also be positioned by a positioning structure. In embodiments where the hash board 20 is mounted on a surface of the cover plate 142 facing away from the bottom plate 1411, preferably, the hash board 20, the cover plate 142, and the bottom plate 1411 are locked by spring screws 30. Each of the spring screws 30 includes a spring, and a screw head and a screw rod which are interconnected, wherein the spring is sleeved on an outer side of the screw rod. In embodiments where the positioning pillars 1414 are arranged on the bottom shell 141, first mounting holes are arranged in each of the positioning pillars 1414; second mounting holes corresponding to the first mounting holes are arranged in the hash board 20 (specifically, the substrate 21). The cover plate 142 is engaged with the bottom shell 141, and corresponding positioning pillars 1414 are in positioning engagement with positioning holes. The hash board 20 is locked to the bottom shell 141 by the spring screws 30 passing through the second mounting holes and engaging with the corresponding first mounting holes. Two ends of the spring of each of the spring screws 30 are respectively abutted against the screw head and the hash board 20. In the embodiments, during assembly of the hash board 20 and the liquid cooling plate 10, by adjusting a pressing force of the spring screws 30, not only is each of the hash chips 22 caused to be in close contact with the enclosure 14, thereby improving a heat dissipation effect; but also damage to the hash chips 22 caused by an excessive pressing force between the hash board 20 and the enclosure 14 is avoided, without adding an additional limiting structure between the enclosure 14 and the hash board 20. Specifically, a plurality of spring screws 30 are respectively arranged on each of the partition strips 1413 and each of the shell walls 1412, so as to better enable each hash chip 22 and the enclosure 14 to be in close contact, and thereby improve heat dissipation performance of the electronic device.

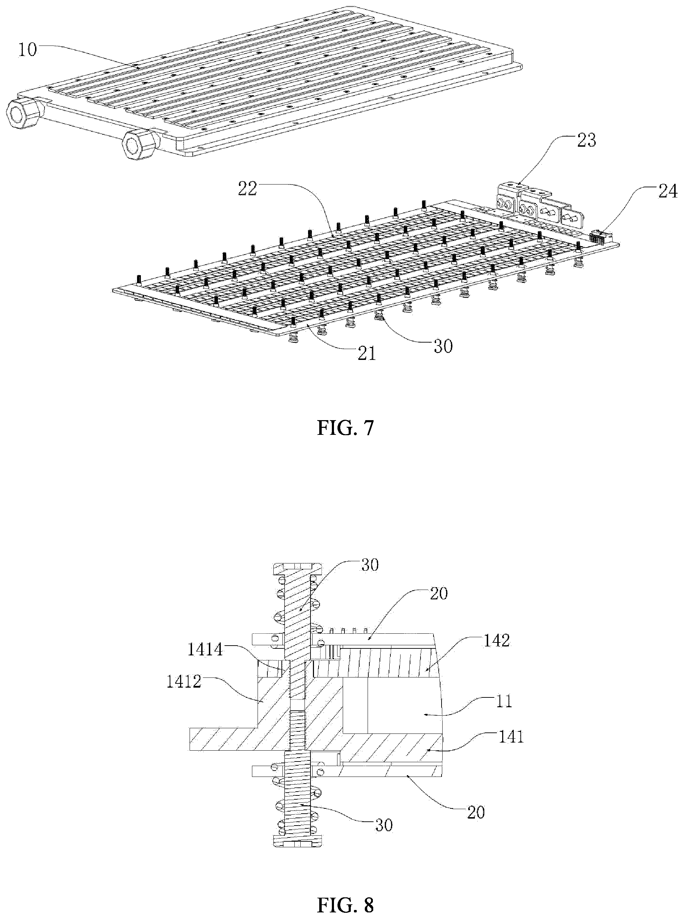

In embodiments where the hash board 20 is mounted on a surface of the bottom plate 1411 facing away from the cover plate 142, the hash board 20 and the enclosure 14 may also be locked by spring screws 30. In the embodiments, the substrate 21 may be directly locked to the first mounting holes in the bottom plate 1411 by passing through the second mounting holes 211 therein. Two ends of the spring of each of the spring screws 30 are respectively abutted against the screw head and the substrate 21. In embodiments where hash boards 20 are respectively mounted on two sides of the enclosure 14, the first mounting holes in the bottom shell 141 may be through holes, as illustrated in FIG. 8. In some other embodiments, the first mounting holes may also be configured as through holes.

Some embodiments of the present disclosure further provide a computing server. The computing server includes the computing liquid cooling unit according to any one of the preceding embodiments. The computing server further includes a chassis, and the computing liquid cooling unit is mounted within the chassis. The medium ports are connected to interface adapter pipes, and the interface adapter pipes extend outside the chassis so as to communicate with an external medium source.

The computing server further includes a power supply unit. The power supply unit and the computing liquid cooling unit are juxtaposed within the chassis. The power supply unit is electrically connected to the hash board to supply power to the hash board.

Some embodiments of the present disclosure further provide a data center. The data center includes the computing server as described above.

A person skilled in the art would understand that the above technical solutions may be freely combined and superimposed as long as no conflicts exist.

It should be understood that the above embodiments are only exemplary, and construe no limitations. Under the circumstance of not departing from the basic principles of the present disclosure, various obvious or equivalent modifications or substitutions that persons skilled in the art may derive to the above-described details are all included within the scope of the claims of the present disclosure.

## Claims

1. A liquid cooling plate for a computing server, the computing server comprising a hash board and the liquid cooling plate, the hash board being mounted on an outer surface of the liquid cooling plate, the hash board comprising a substrate and a plurality of hash chips, the plurality of hash chips forming a plurality of rows of chipsets on a same side of the substrate; wherein
the liquid cooling plate comprises a medium flow channel, heat dissipation fins, and a flow guide structure; wherein the medium flow channel is arranged corresponding to the chipsets; the medium flow channel has a channel end wall at each of both ends of the medium flow channel in an extension direction of the medium flow channel, medium ports being arranged in the channel end walls; and the heat dissipation fins are arranged within the medium flow channel and are disposed between the two channel end walls, dividing the medium flow channel into a plurality of sub-flow channels; and
the flow guide structure is arranged at least between one of the channel end walls and the heat dissipation fins, and the flow guide structure is evenly spaced apart from the channel end wall on a side where the flow guide structure is disposed and from the heat dissipation fins;
wherein the flow guide structure comprises a first flow guide plate and a second flow guide plate that are arranged opposite to each other; wherein the first flow guide plate and the second flow guide plate protrude in directions facing away from each other; and a gap is defined between the first flow guide plate and the second flow guide plate in a width direction of the medium flow channel, a dimension of the gap at an end closer to the channel end wall is less than a dimension of the gap at an end closer to the heat dissipation fins.

2. The liquid cooling plate according to claim 1, wherein each of the first flow guide plate and the second flow guide plate comprises a first straight plate segment and a second straight plate segment that are connected by a bend; wherein the first straight plate segment is closer to the medium port, and for each of two said first straight plate segments, one end thereof closer to the channel end wall is further away from the channel side wall than the other end thereof; and two said second straight plate segments are arranged in parallel.

3. The liquid cooling plate according to claim 2, wherein in the extension direction, a dimension of the first straight plate segment is greater than a dimension of the second straight plate segment.

4. The liquid cooling plate according to claim 2, wherein an included angle between the two first straight plate segments is from 45° to 75°.

5. The liquid cooling plate according to claim 1, wherein at an end of the flow guide structure closer to the medium port, a distance between the first flow guide plate and the second flow guide plate is 1/3 to 1/2 of a maximum width of the medium port, wherein the width of the medium port is a dimension in the width direction of the medium flow channel.

6. The liquid cooling plate according to claim 1, wherein the first flow guide plate and the second flow guide plate are both curved plates.

7. The liquid cooling plate according to claim 1, wherein for each of the first flow guide plate and the second flow guide plate, an end face thereof closer to the channel end wall and two opposite side surfaces thereof are smoothly transitioned.

8. The liquid cooling plate according to claim 1, wherein the flow guide structure further comprises a third flow guide plate, wherein the third flow guide plate is disposed between the first flow guide plate and the second flow guide plate.

9. The liquid cooling plate according to claim 1, wherein one of the medium ports is a liquid inlet, and the flow guide structure is arranged at the liquid inlet; and a plurality of the heat dissipation fins are juxtaposed in the width direction of the medium flow channel, and ends of the plurality of the heat dissipation fins closer to the liquid inlet are flush.

10. The liquid cooling plate according to claim 9, wherein the plurality of the heat dissipation fins are spaced apart along the extension direction to form a plurality of heat dissipation groups, each of the heat dissipation groups comprising a plurality of the heat dissipation fins; and
the medium flow channel comprises a plurality of sub-segments sequentially communicated; wherein in a sub-segment where the liquid inlet is disposed, both a distance between the heat dissipation group closest to the flow guide structure and the flow guide structure and a distance between two heat dissipation groups closest to the flow guide structure are greater than a distance between any adjacent heat dissipation groups of the plurality of heat dissipation groups.

11. A imputing liquid cooling unit, comprising a liquid cooling plate as defined in any one of claims 1 to 10.

12. The computing liquid cooling unit according to claim 11, further comprising: a hash board, the hash board being mounted on an outer side surface of the liquid cooling plate; wherein
an enclosure of the liquid cooling plate comprises a bottom shell and a cover plate that are fitted to each other, the bottom shell comprising a bottom plate, a shell wall protruding from the bottom plate, and a partition strip, the partition strip being disposed within the shell wall; wherein the partition strip, the shell wall, the bottom plate, and the cover plate form a medium flow channel; a plurality of positioning pillars are arranged on at least a partial segment of each of the partition strip and the shell wall, first mounting holes being arranged in the positioning pillars; positioning holes corresponding to the positioning pillars are arranged in the cover plate; and the heat dissipation fins and the flow guide structure are both disposed on the bottom plate;
second mounting holes corresponding to the first mounting holes are arranged in the hash board; and
the cover plate is fitted onto the bottom plate, the positioning pillars and positioning holes that are in correspondence are in a positioning fit configuration, and the hash board is locked onto the bottom shell by spring screws engaging with the corresponding first mounting holes, wherein two ends of a spring of the spring screw are disposed between the screw head and the hash board.

13. The computing liquid cooling unit according to claim 12, wherein the positioning pillars are arranged on two opposite first segments of the shell wall in the width direction, and a positioning boss is further arranged on a second segment connecting two said first segments; and a positioning notch is arranged in a corresponding edge of the cover plate, and the positioning boss is in positioning engagement with the positioning notch.

14. The computing liquid cooling unit according to claim 11, wherein the hash board comprises a substrate, a plurality of hash chips, a power supply interface, and a signal interface; wherein the plurality of hash chips are arranged on a same surface of the substrate and are in contact with the liquid cooling plate; and the power supply interface and the signal interface are arranged at a same edge of the substrate and are both electrically connected to the hash chips.

15. A computing server, comprising: a computing liquid cooling unit according to any one of claims 11 to 14.
